# EUROPÄISCHE PATENTSCHRIFT

(11) **EP 2 657 691 B1**
(45) Veröffentlichungstag und Bekanntmachung des Hinweises auf die Patenterteilung: **29.08.2018**
(21) Anmeldenummer: 13164715.8
(22) Anmeldetag: 22.04.2013
(51) Int. Cl.: G01N 27/22

(54) **Feuchtesensor-Anordnung**
Moisture sensor assembly
Agencement de détecteur d'humidité

(30) Priorität: 25.04.2012 DE 102012008118
(43) Veröffentlichungstag der Anmeldung: 30.10.2013
(73) Patentinhaber: E+E Elektronik Ges.m.b.H., 4209 Engerwitzdorf (AT)
(72) Erfinder: Mayer, Elmar, 83365 Nußdorf (DE); Niessner, Georg, 4223 Katsdorf (AT); Runck, Joachim, 4030 Linz (AT)
(74) Vertreter: Hofmann, Ernst

(56) Entgegenhaltungen:
- WO-A1-2007/014800
- DE-A1- 10 225 373
- US-A1- 2006 048 572
- US-A1- 2008 283 991
- US-B1- 6 249 136
- RITTERSMA Z M: "Recent achievements in miniaturised humidity sensors-a review of transduction techniques", SENSORS AND ACTUATORS A, ELSEVIER SEQUOIA S.A., LAUSANNE, CH, Bd. 96, Nr. 2-3, 28. Februar 2002 (2002-02-28), Seiten 196-210, XP004343629, ISSN: 0924-4247, DOI: 10.1016/S0924-4247(01)00788-9

## Beschreibung

Die vorliegende Erfindung betrifft eine Feuchtesensor-Anordnung.

Aus der EP 1 236 038 B1 ist eine Sensoranordnung bekannt, die einen Halbleiterchip umfasst, auf dem ein kapazitiver Feuchtesensor angeordnet ist. Der kapazitive Feuchtesensor besteht aus zwei nebeneinander platzierten Interdigitalelektroden und einer dielektrischen Messschicht, die feuchteabhängig ihre Kapazität ändert. Die derart generierten Messsignale werden im Halbleiterchip weiterverarbeitet und geeignet für eine Übertragung an eine Folgeelektronik aufbereitet. In Bezug auf die Kontaktierung des Halbleiterchips und die Montage der Sensoranordnung, z.B. auf einer Platine, sind dieser Druckschrift keine weiteren Hinweise zu entnehmen.

Die US 7,181,966 B2 offenbart eine weitere Sensoranordnung, die auf der Oberseite eines ersten Halbleiter-Substrats einen Sensor aufweist, beispielsweise einen kapazitiven Feuchtesensor. Auf der gegenüberliegenden Unterseite des ersten Halbleitersubstrats ist ein zweites Halbleiter-Substrat mit einem darauf angeordneten Signalverarbeitungsbaustein. Dieser ist etwa als CMOS-ASIC ausgebildet. Eine elektrisch leitende Verbindung zwischen dem Sensor und dem Signalverarbeitungsbaustein wird über Durchkontaktierungen im ersten Halbleiter-Substrat hergestellt. Nachteilig an dieser Lösung ist, dass zwei Halbleiter-Substrate für den Gesamtaufbau der Sensoranordnung erforderlich sind.

In der US 2011/0079649 A1 wird eine Sensoranordnung vorgeschlagen, bei der auf einer Seite eines Halbleiter-Substrats ein Sensor angeordnet ist, beispielsweise ein kapazitiver Feuchtesensor mit Interdigitalelektroden. Auf der gegenüberliegenden Seite des Halbleiter-Substrats ist ein CMOS-Signalverarbeitungsbaustein ohne eigenes Trägersubstrat angeordnet. Auch hier sind der Sensor und der CMOS-Signalverarbeitungsbaustein über Durchkontaktierungen im Halbleitersubstrat elektrisch miteinander verbunden. Details zur Ausbildung des CMOS-Signalverarbeitungsbausteins finden sich in dieser Druckschrift nicht.

Aufgabe der vorliegenden Erfindung ist es, eine kompakt bauende und einfach zu kontaktierende Feuchtesensor-Anordnung anzugeben, über die eine zuverlässige Messung der Umgebungsfeuchte möglich ist.

Diese Aufgabe wird erfindungsgemäß durch eine Feuchtesensor-Anordnung mit den Merkmalen des Anspruchs 1 gelöst.

Vorteilhafte Ausführungen der erfindungsgemäßen Feuchtesensor-Anordnung ergeben sich aus den Maßnahmen in den abhängigen Ansprüchen.

Die erfindungsgemäße Feuchtesensor-Anordnung umfasst ein plattenförmiges Halbleitersubstrat mit einem integrierten Signalverarbeitungsbaustein, der unmittelbar benachbart auf einer Seite des Halbleitersubstrats angeordnet und als gehäuseloser CMOS-Schichtstapel ausgebildet ist und einen kapazitiven Feuchtesensor, der elektrisch leitend mit dem Signalverarbeitungsbaustein verbunden und entweder auf der gleichen oder der entgegengesetzten Seite des Halbleitersubstrats wie der Signalverarbeitungsbaustein angeordnet ist. Das Halbleitersubstrat weist Durchkontaktierungen auf, über die Elemente auf gegenüberliegenden Seiten des Halbleitersubstrats miteinander elektrisch verbindbar sind. Ferner ist im Signalverarbeitungsbaustein mindestens ein Temperatursensor integriert.

Vorzugsweise umfasst der Signalverarbeitungsbaustein mindestens folgende weitere Komponenten:
- mindestens eine Analog-Digital-Wandlereinheit zum Einlesen und Digitalisieren der analogen Messsignale des Feuchtesensors und des Temperatursensors,
- eine Auswerteeinheit zur Bestimmung der Messgröße aus den eingelesenen Messsignalen,
- eine digitale Schnittstelleneinheit zur seriellen Übertragung der bestimmten Messgröße an eine nachgeordnete Folgeelektronik.

Es ist möglich, dass der kapazitive Feuchtesensor mindestens zwei Elektroden und eine feuchteempfindliche Messschicht umfasst.

Dabei kann der kapazitive Feuchtesensor als Plattenkondensator mit mindestens einer Grundelektrode und mindestens einer Deckelektrode ausgebildet sein, zwischen denen die feuchteempfindliche Messschicht angeordnet ist.

In einer möglichen Variante umfasst der Feuchtesensor eine einzige, flächige Grundelektrode und eine einzige flächige Deckelektrode, die jeweils elektrisch leitend mit dem Signalverarbeitungsbaustein verbunden sind.

Alternativ kann aber auch vorgesehen werden, dass der Feuchtesensor mehrere flächige Grundelektroden und eine einzige flächige Deckelektrode umfasst und lediglich die Grundelektroden elektrisch leitend mit dem Signalverarbeitungsbaustein verbunden sind.

Mit Vorteil sind auf der dem Feuchtesensor gegenüberliegenden Seite des Halbleitersubstrats kugelförmige Kontaktierungselemente angeordnet.

Es ist möglich, dass die Feuchtesensor-Anordnung ferner einen nichtflüchtigen Speicher umfasst, in dem Kalibrierdaten bezüglich des Temperatursensors abgelegt sind, auf welche die Auswerteeinheit zur Temperaturbestimmung zugreift.

In einer Ausführungsform kann vorgesehen sein, dass der Feuchtesensor in vertikaler Richtung über dem Signalverarbeitungsbaustein angeordnet ist und der Signalverarbeitungsbaustein über die Durchkontaktierungen im Halbleitersubstrat mit Kontaktierungselementen auf der gegenüberliegenden Seite des Halbleitersubstrats elektrisch leitend verbunden ist.

Hierbei kann über die Durchkontaktierungen im Halbleitersubstrat die Energieversorgung des Signalverarbeitungsbausteins und die serielle Übertragung der Messgröße an die Folgeelektronik erfolgen.

In einer weiteren Ausführungsform kann vorgesehen sein, dass der Signalverarbeitungsbaustein auf seiner dem Feuchtesensor zugewandten Seite eine Isolationsschicht aufweist, auf der die mindestens eine Grundelektrode des Feuchtesensors angeordnet ist, über der die feuchteempfindliche Messschicht des Feuchtesensors angeordnet ist und über der die Deckelektrode des Feuchtesensors angeordnet ist.

Es kann hierbei der Feuchtesensor und der Signalverarbeitungsbaustein auf gegenüberliegenden Seiten des Halbleitersubstrats angeordnet und über die Durchkontaktierungen im Halbleitersubstrat elektrisch leitend miteinander verbunden sein.

Als ein Vorteil der erfindungsgemäßen Feuchtesensor-Anordnung resultiert eine äußerst kompakte Bauform. Die elektrische Kontaktierung der Feuchtesensor-Anordnung erfordert keine Bonddrähte, so dass sich der Platzbedarf des Signalverarbeitungsbausteins auf die Außenmaße desselbigen reduziert. Auch auf ein zusätzliches Gehäuse zum Schutz der Bonddrähte kann verzichtet werden, was sich ebenfalls positiv in Bezug auf einen geringen Platzbedarf erweist. Desweiteren kann nahezu die gesamte Fläche des Signalverarbeitungsbausteins für den Feuchtsensor genützt werden, wodurch sich eine höhere Genauigkeit der erfindungsgemäßen Feuchtesensor-Anordnung erreichen lässt.

Über die Integration des Temperatursensors in den Signalverarbeitungsbaustein ist zudem gewährleistet, dass die zur Feuchtebestimmung erforderliche Temperaturmessung in einem idealen Abstand zum Messpunkt der Kapazitätsmessung erfolgt.

Weitere Vorteile sowie Einzelheiten der vorliegenden Erfindung ergeben sich aus der nachfolgenden Beschreibung von Ausführungsbeispielen anhand der beiliegenden Figuren.

Es zeigt hierbei
- Figur 1: eine seitliche Schnittansicht eines ersten Ausführungsbeispiels der erfindungsgemäßen Feuchtesensor-Anordnung;
- Figur 2: eine seitliche Schnittansicht eines zweiten Ausführungsbeispiels der erfindungsgemäßen Feuchtesensor-Anordnung;
- Figur 3: eine seitliche Schnittansicht eines dritten Ausführungsbeispiels der erfindungsgemäßen Feuchtesensor-Anordnung;
- Figur 4: eine seitliche Schnittansicht eines vierten Ausführungsbeispiels der erfindungsgemäßen Feuchtesensor-Anordnung.

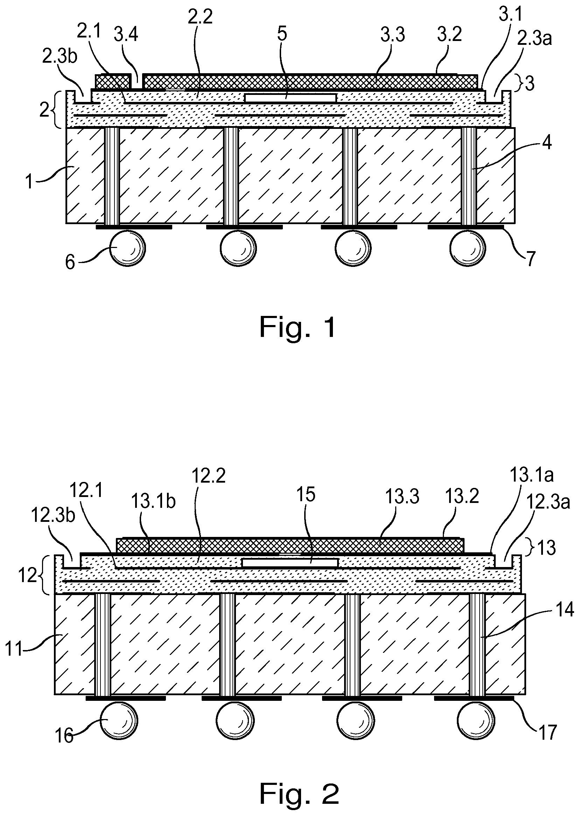

In Figur 1 ist ein erstes Ausführungsbeispiel der erfindungsgemäßen Feuchtesensor-Anordnung in stark schematisierter Art und Weise dargestellt.

Die erfindungsgemäße Feuchtesensor-Anordnung umfasst ein plattenförmig ausgebildetes Halbleitersubstrat 1, beispielsweise ein Silizium-Substrat, auf dem die verschiedenen Elemente der -Anordnung platziert sind. Im dargestellten ersten Ausführungsbeispiel ist auf der Oberseite des Halbleitersubstrats 1 ein integrierter Signalverarbeitungsbaustein 2 angeordnet. Der Signalverarbeitungsbaustein 2 ist als gehäuseloser CMOS-Schichtstapel aufgebaut, in den verschiedene elektronische Komponenten zur Signalverarbeitung und Signalaufbereitung integriert ausgebildet sind. Wiederum oberhalb des Signalverarbeitungsbausteins 2, d.h. in vertikaler Richtung benachbart zum Signalverarbeitungsbaustein 2, ist ein kapazitiver Feuchtesensor 3 angeordnet. Der Feuchtesensor 3 ist elektrisch leitend mit dem Signalverarbeitungsbaustein 2 verbunden. Die vom Feuchtesensor 3 erzeugten, analogen Messsignale werden im Signalverarbeitungsbaustein 2 verarbeitet, insbesondere die gesuchte Messgröße "Relative Feuchte" aus den Messsignalen bestimmt und die Messgröße für eine serielle Übertragung an eine nachgeordnete Folgeelektronik aufbereitet; nachfolgend sei in Bezug auf die Messgröße lediglich von der Messgröße "Feuchte" die Rede. Um eine derartige Signalverarbeitung zu bewerkstelligen umfasst der Signalverarbeitungsbaustein 2 als integrierte elektronische Komponente eine Analog-Digital-Wandlereinheit, die zum Einlesen und Digitalisieren der analogen Messsignale des Feuchtesensors 3 dient. Ferner ist als weitere elektronische Komponente eine Auswerteeinheit im Signalverarbeitungsbaustein 2 vorgesehen, die die Messgröße "Feuchte" aus den Messsignalen des Feuchtesensors 3 ermittelt. Als weitere elektronische Komponente ist schließlich noch eine geeignet ausgebildete Schnittstelleneinheit vorgesehen, die zur seriellen Übertragung der Messgröße an die Folgeelektronik dient.
Zusätzlich zu diesen - nicht im einzelnen dargestellten - elektronischen Komponenten ist im Signalverarbeitungsbaustein 2 erfindungsgemäß ein Temperatursensor 5 integriert, der in Figur 1 schematisch angedeutet ist. Der Temperatursensor 5 liefert Messsignale in Bezug auf die Umgebungstemperatur, die von der Auswerteeinheit des Signalverarbeitungsbausteins 2 neben den Messsignalen des Feuchtesensors 3 zur präzisen Bestimmung der Messgröße "Feuchte" herangezogen wird. Die benachbarte Anordnung von Feuchtesensor 3 und Temperatursensor 5 in der erfindungsgemäßen Feuchtesensor-Anordnung ermöglicht hierbei eine besonders gute Bestimmung der Messgröße "Feuchte".

Die Temperaturbestimmung erfolgt hierbei über die Auswerteeinheit. Hierzu wird die Bandgap-Spannung des Halbleitermaterials des Temperatursensors der Auswerteeinheit über die oben erwähnte Analog-Digital-Wandlereinheit digitalisiert zugeführt. Alternativ könnte auch eine weitere Analog-Digital-Wandlereinheit zu diesem Zweck in der erfindungsgemäßen Feuchtesensor-Anordnung vorgesehen werden.

Zur hochgenauen Bestimmung der Messgröße "Feuchte" erweist es sich ferner als vorteilhaft, wenn der Temperaturwert nachkalibriert wird. Hierzu weist die erfindungsgemäße Feuchtesensor-Anordnung einen nichtflüchtigen Speicher auf, in dem Kalibrierdaten bezüglich des Temperatursensors abgelegt sind, auf welche die Auswerteeinheit zur Temperaturbestimmung zugreift.

Der als CMOS-Schichtstapel ausgebildete Signalverarbeitungsbaustein 2 weist in Richtung des Feuchtesensors 3 eine letzte Metallisierungsschicht 2.1 auf, die als Abschirmschicht fungiert und eine eventuelle Beeinträchtigung der Signalverarbeitung durch den Feuchtesensor 3 im Signalverarbeitungsbaustein 2 minimiert. Über der letzten Metallisierungsschicht 2.1 ist im Signalverarbeitungsbaustein 2 desweiteren noch eine Isolationsschicht 2.2 angeordnet, die z.B. als SiN-Schicht oder als SiO₂-Schicht ausgebildet sein kann. Die Isolationsschicht 2.2 gewährleistet eine elektrische Isolierung des Signalverarbeitungsbausteins 2 vom darüber angeordneten Feuchtesensor 3.

Über der Isolationsschicht 2.2 des Signalverarbeitungsbausteins 2 ist eine flächig ausgebildete Grundelektrode 3.1 des kapazitiven Feuchtesensors 3 angeordnet, darüber eine feuchteempfindliche Messschicht 3.3 und über der Messschicht 3.3 schließlich eine flächig ausgebildete Deckelektrode 3.2. Die Grundelektrode 3.1, 3.2 besteht hierbei aus Nickel/Chrom und Gold; alternativ wäre auch Aluminium in Verbindung mit einer Isolatorschicht aus Quarz oder SiN verwendbar. Als Material für die Deckelektrode 3.2 ist Chrom vorgesehen. Als Messschicht 3.3, deren Kapazität sich feuchteabhängig ändert, dient ein geeignetes Dielektrikum wie z.B. Polyimid.

Im vorliegenden ersten Ausführungsbeispiel der erfindungsgemäßen Feuchtesensor-Anordnung ist der kapazitive Feuchtesensor 3 demzufolge als Plattenkondensator ausgebildet, der zwei flächige Elektroden in Form einer Grund- und einer Deckelektrode 3.1, 3.2 umfasst, zwischen denen die feuchteempfindliche Messschicht 3.3 angeordnet wird.

In einer hierzu alternativen Ausführungsform wäre es grundsätzlich möglich, die Elektroden des kapazitiven Feuchtesensors als fingerförmig ausgebildete Interdigitalelektroden auszuführen, über denen dann die feuchteempfindliche Messschicht angeordnet wird.

Der Feuchtesensor 3 bzw. in diesem Ausführungsbeispiel dessen Grundelektrode 3.1 und dessen Deckelektrode 3.2 sind elektrisch leitend mit dem Signalverarbeitungsbaustein 2 verbunden. Die auf der Isolationsschicht 2.2 des CMOS-Schichtstapels angeordnete Grundelektrode 3.1 wird im dargestellten Beispiel über den rechts außen in Figur 1 gezeigten ersten Kontaktierungsbereich 2.3a mit dem Signalverarbeitungsbaustein 2 verbunden. Um die Deckelektrode 3.2 mit dem Signalverarbeitungsbaustein 2 elektrisch leitend zu verbinden, weist die Messschicht 3.2 einen Durchbruch 3.4 auf, über den eine Verbindung zu einem zweiten Kontaktierungsbereich 2.3b des Signalverarbeitungsbausteins 2 hergestellt werden kann.

Das Halbleitersubstrat 1 weist desweiteren mehrere Durchkontaktierungen 4 in Form zylinderförmiger Durchbrüche zwischen der Ober- und Unterseite auf, über die Elemente auf den gegenüberliegenden Seiten des Halbleitersubstrats 1 miteinander elektrisch leitend verbindbar sind. Hierzu ist in den Durchkontaktierungen 4 ein geeignetes elektrisch leitfähiges Material angeordnet, beispielsweise Aluminium oder Kupfer.

Im ersten Ausführungsbeispiel der erfindungsgemäßen Feuchtesensor-Anordnung sind auf der Unterseite des Halbleitersubstrats 1 mehrere kugelförmig ausgebildete Kontaktierungselemente 6 angeordnet. Über die Kontaktierungselemente 6 lässt sich die gezeigte Feuchtesensor-Anordnung auf einem Trägerelement, z.B. einer Platine, anordnen.

Mittels der Durchkontaktierungen 4 wird im dargestellten ersten Ausführungsbeispiel somit der Signalverarbeitungsbaustein 2 auf der Oberseite des Halbleitersubstrats 1 mit den Kontaktierungselementen 6 auf der Unterseites desselbigen elektrisch leitend verbunden. Über die Durchkontaktierungen 4 erfolgt hierbei konkret die Energieversorgung des Signalverarbeitungsbausteins 2 sowie die serielle Übertragung der Messgröße vom Signalverarbeitungsbaustein 2 an eine - nicht dargestellte - Folgeelektronik, in der diese Messgröße weitergenutzt werden kann.

Im dargestellten Ausführungsbeispiel sind hierbei die Kontaktierungselemente 6 nicht unmittelbar mit den Durchkontaktierungen 4 verbunden; auf der Unterseite des Halbleitersubstrats 1 ist zusätzlich noch eine elektrisch leitende Umverdrahtungsschicht 7 vorgesehen, über die die Position der Kontaktierungselemente 6 geeignet festgelegt werden kann.

Die erfindungsgemäße Feuchtesensor-Anordnung kann somit elektrisch kontaktiert werden, ohne dass hierzu Bonddrähte nötig sind. Die ausschließlich auf der Unterseite des Halbleitersubstrats 1 angeordneten Kontaktierungselemente 6 ermöglichen bei der Weiterverarbeitung eine automatisierte SMD-Bestückung.

Ein zweites Ausführungsbeispiel der erfindungsgemäßen Feuchtesensor-Anordnung ist in Figur 2 in einer wiederum stark schematisierten Schnittansicht gezeigt. Nachfolgend seien lediglich die maßgeblichen Unterschiede zum vorab beschriebenen ersten Ausführungsbeispiel erläutert.

Diese bestehen i.w. in einer etwas modifizierten Ausbildung des kapazitiven Feuchtesensors 13. Dieser umfasste im ersten Ausführungsbeispiel eine einzige flächige Grundelektrode und eine einzige flächige Deckelektrode, die jeweils elektrisch leitend mit dem Signalverarbeitungsbaustein verbunden sind. Im Unterschied hierzu ist im zweiten Ausführungsbeispiel nunmehr vorgesehen, mehrere flächige Grundelektroden 13.1a, 13.1b auf der Isolationsschicht 13.2 des Signalverarbeitungsbausteins 13 anzuordnen. Darüber ist wie im ersten Beispiel eine feuchteempfindliche Messschicht 13.3 sowie eine einzige flächige Deckelektrode 13.2 angeordnet. Lediglich die mehreren Grundelektroden 13.1a, 13.1b sind hierbei elektrisch leitend über die Kontaktierungsbereiche 12.3a, 12.3b mit dem Signalverarbeitungsbaustein 12 verbunden. Aufgrund der nicht erforderlichen Kontaktierung der Deckelektrode 13.2 entfällt der im ersten Beispiel erforderliche Durchbruch in der Messschicht 13.3 sowie die dort erforderliche Strukturierung der Deckelektrode.

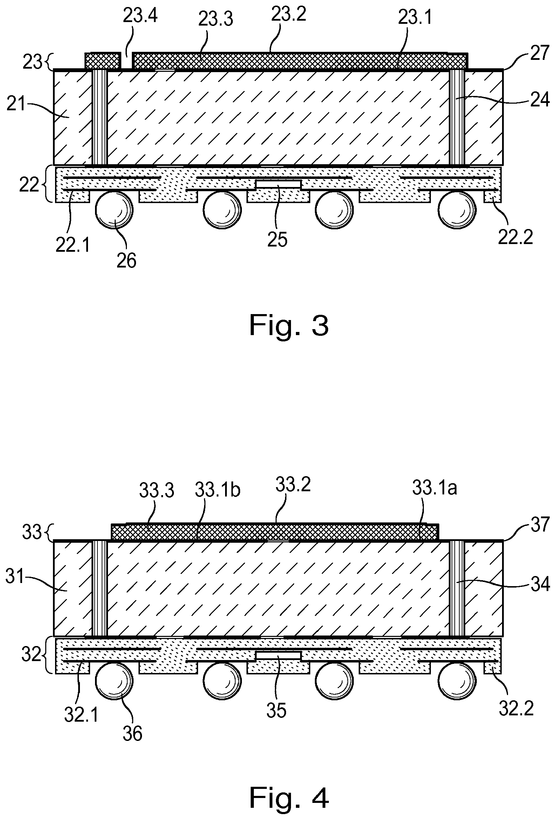

Eine drittes Ausführungsbeispiel der erfindungsgemäßen Feuchtesensor-Anordnung ist in einer seitlichen Schnittansicht in Figur 3 schematisiert dargestellt. Auch von diesem Beispiel seien lediglich die maßgeblichen Unterschiede zu den vorhergehenden Varianten erläutert.

So ist hier nunmehr vorgesehen, den kapazitiven Feuchtesensor 23 und den Signalverarbeitungsbaustein 22 auf den gegenüberliegenden Seiten des Halbleitersubstrats 21 anzuordnen. Auf der Oberseite des Halbleitersubstrats 21 ist der Feuchtesensor 23 mit einer flächig ausgebildeten Grundelektrode 23.1, einer darüber angeordneten feuchteempfindlichen Messschicht 23.3 sowie einer nach oben abschließenden Deckelektrode 23.2 angeordnet. Zwischen der Grundelektrode 23.1 und der Oberseite des Halbleitersubstarts 21 ist im gezeigten Beispiel desweiteren noch eine elektrisch leitende Umverdrahtungsschicht 27 angeordnet. Über diese kann die elektrisch leitende Verbindung der Grundelektrode 23.1 sowie der Deckelektrode 23.2 mit den Durchkontaktierungen 24 im Halbleitersubstrat flexibel angepasst werden. Zwingend erforderlich ist eine derartige Umverdrahtungsschicht 27 grundsätzlich in der erfindungsgemäßen Feuchtesensor-Anordnung nicht.

Auf der gegenüberliegenden Seite des Halbleitersubstrats 21, d.h. auf dessen Unterseite ist in dieser Ausführungsform der Signalverarbeitungsbaustein 23 angeordnet. Dieser umfasst wie bereits in den ersten beiden Ausführungsbeispielen neben verschiedenen elektronischen Komponenten einen darin intergierten Temperatursensor 25. Dessen Messsignale werden zusammen mit den Messsignalen des kapazitiven Feuchtesensors 23 im Signalverarbeitungsbaustein zur Ermittlung der Messgröße "Feuchte" herangezogen.

Die konkrete Ausbildung des kapazitiven Feuchtesensors mit einer einzigen flächigen Grundelektrode 23.1 und einer einzigen flächigen Deckelektrode 23.2 und der elektrischen Verbindung beider Elektroden mit dem Signalverarbeitungsbaustein 23 entspricht grundsätzlich dem ersten erläuterten Ausführungsbeispiel; wie oben ist auch hier ein geeigneter Durchbruch 23.4 in der feuchteempfindlichen Messschicht 23.3 vorzusehen, um die Deckelektrode 23.2 zu kontaktieren.

Über die Durchkontaktierungen 24 im Halbleitersubstrat 21 werden in diesem Ausführungsbeispiel demzufolge die analogen Messsignale des Feuchtesensors 23 zum Signalverarbeitungsbaustein 22 übertragen.

Die kugelförmigen Kontaktierungselemente 26 sind hier ebenfalls auf der Unterseite des Halbleitersubstrats 21 vorgesehen, auf der sich auch der Signalverarbeitungsbaustein 23 befindet. Wie aus der Figur 3 ersichtlich, sind die Kontaktierungselemente 26 hierbei an Stellen vorgesehen, an denen die Isolationsschicht 22.2 des Signalverarbeitungsbausteins 23 entfernt ist und wo die Kontaktierungselemente 26 elektrisch leitend mit der letzten Metallisierungsschicht 22.1 verbunden sind.

Diese Variante der erfindungsgemäßen Feuchtesensor-Anordnung erweist sich hierbei als vorteilhaft in Bezug auf eine möglichst geringe gegenseitige Beeinflussung des Feuchtesensors 23 und des Signalverarbeitungsbausteins 22. Diese Komponenten besitzen aufgrund der vorgesehenen Anordnung auf gegenüberliegenden Seiten des Halbleitersubstrats 21 einen deutlich größeren Abstand als in den beiden vorhergehenden Ausführungsbeispielen, so dass insbesondere die thermische Beeinflussung des Feuchtesensors 23 aufgrund der Abwärme des Signalverarbeitungsbausteins 22 minimiert werden kann.

Als weiterer Vorteil dieser Variante ist anzuführen, dass sich darüber der Aufwand in der Fertigung der Feuchtesensor-Anordnung verringern lässt, da hier Standardverfahren für die Montage der Kontaktierungselemente 26 zur elektrischen Kontaktierung verwendet werden können, wie sie z.B. bei sog. Flip-Chip-ASICs bekannt sind.

Ein viertes Ausführungsbeispiel der erfindungsgemäßen Feuchtesensor-Anordnung ist in einer schematisierten Schnittansicht in Figur 4 gezeigt.

In Bezug auf die Anordnung des Feuchtesensors 33 und des Signalverarbeitungsbausteins 32 auf gegenüberliegenden Seiten des Halbleitersubstrats 31 entspricht diese Variante dem dritten Ausführungsbeispiel. Unterschiedlich hierzu ist lediglich der kapazitive Feuchtesensor 33 ausgebildet. Wie im zweiten Ausführungsbeispiel sind wiederum zwei Grundelektroden 33.1a, 33.1b vorgesehen, die über die Durchkontaktierungen 34 elektrisch mit dem Signalverarbeitungsbaustein 32 verbunden werden. Nicht elektrisch kontaktiert wird hingegen die über der Messschicht 33.3 angeordnete Deckelektrode 33.2. Ansonsten entspricht das vierte Ausführungsbeispiel der erfindungsgemäßen Feuchtesensor-Anordnung dem vorhergehenden Beispiel.

Neben den erläuterten Ausführungsbeispielen gibt es im Rahmen der vorliegenden Erfindung selbstverständlich noch weitere alternative Ausgestaltungsmöglichkeiten.

## Patentansprüche

1. Feuchtesensor-Anordnung mit
- einem plattenförmigen Halbleitersubstrat (1; 11; 21; 31),
- einem integrierten Signalverarbeitungsbaustein (2; 12; 22; 32), der unmittelbar benachbart auf einer Seite des Halbleitersubstrats (1; 11; 21; 31) angeordnet und als gehäuseloser CMOS-Schichtstapel ausgebildet ist,
- einem kapazitiven Feuchtesensor (3; 13; 23; 33), der elektrisch leitend mit dem Signalverarbeitungsbaustein (1; 11; 21; 31) verbunden und entweder auf der gleichen oder der entgegengesetzten Seite des Halbleitersubstrats (1; 11; 21; 31) wie der Signalverarbeitungsbaustein (2; 12; 22; 32) angeordnet ist, wobei
- das Halbleitersubstrat (1; 11; 21; 31) Durchkontaktierungen (4; 14; 24; 34) aufweist, über die Elemente auf gegenüberliegenden Seiten des Halbleitersubstrats (1; 11; 21; 31) miteinander elektrisch verbindbar sind und
- mindestens einem im Signalverarbeitungsbaustein (2; 12; 22; 32) integrierten Temperatursensor (5; 15; 25; 35)

2. Feuchtesensor-Anordnung nach Anspruch 1, wobei der Signalverarbeitungsbaustein (2; 12; 22; 32) mindestens folgende weitere Komponenten umfasst:
- mindestens eine Analog-Digital-Wandlereinheit zum Einlesen und Digitalisieren der analogen Messsignale des Feuchtesensors (3; 13; 23; 33) und des Temperatursensors (5; 15; 25; 35),
- eine Auswerteeinheit zur Bestimmung der Messgröße aus den eingelesenen Messsignalen,
- eine digitale Schnittstelleneinheit zur seriellen Übertragung der bestimmten Messgröße an eine nachgeordnete Folgeelektronik.

3. Feuchtesensor-Anordnung nach Anspruch 1, wobei der kapazitive Feuchtesensor (3; 13; 23; 33) mindestens zwei Elektroden (3.1, 3.2; 13.1a, 13.1b, 13.2; 23.1, 23.2; 33.1a, 33.1b, 33.2) und eine feuchteempfindliche Messschicht (3.3; 13.3; 23.3; 33.3) umfasst.

4. Feuchtesensor-Anordnung nach Anspruch 3, wobei der kapazitive Feuchtesensor (3; 13; 23; 33) als Plattenkondensator mit mindestens einer Grundelektrode (3.1; 13.1a, 13.1b; 23.1; 33.1a, 33.1b) und mindestens einer Deckelektrode (3.2; 13.2; 23.2; 33.3) ausgebildet ist, zwischen denen die feuchteempfindliche Messschicht (3.3; 13.3; 23.3; 33.3) angeordnet ist.

5. Feuchtesensor-Anordnung nach Anspruch 3, wobei der Feuchtesensor (3; 23) eine einzige, flächige Grundelektrode (3.1; 23.1) und eine einzige flächige Deckelektrode (3.2; 23.2) umfasst, die jeweils elektrisch leitend mit dem Signalverarbeitungsbaustein (2; 22) verbunden sind.

6. Feuchtesensor-Anordnung nach Anspruch 3, wobei der Feuchtesensor (13; 33) mehrere flächige Grundelektroden (13.1a, 13.1b; 33.1a, 33.1b) und eine einzige flächige Deckelektrode (13.2; 33.2) umfasst und lediglich die Grundelektroden (13.1a, 13.1b; 33.1a, 33.1b) elektrisch leitend mit dem Signalverarbeitungsbaustein (12; 32) verbunden sind.

7. Feuchtesensoranordnung nach mindestens einem der vorhergehenden Ansprüche, wobei auf der dem Feuchtesensor (3; 13; 23; 33) gegenüberliegenden Seite des Halbleitersubstrats (1; 11; 21; 31) kugelförmige Kontaktierungselemente (6) angeordnet sind.

8. Feuchtesensor-Anordnung nach Anspruch 2, die ferner einen nichtflüchtigen Speicher umfasst, in dem Kalibrierdaten bezüglich des Temperatursensors (5; 15; 25; 35) abgelegt sind, auf welche die Auswerteeinheit zur Temperaturbestimmung zugreift.

9. Feuchtesensor-Anordnung nach mindestens einem der Ansprüche 1-8, wobei der Feuchtesensor (3; 13) in vertikaler Richtung über dem Signalverarbeitungsbaustein (2; 12) angeordnet ist und der Signalverarbeitungsbaustein (2; 12) über die Durchkontaktierungen (4; 14) im Halbleitersubstrat (1; 11) mit Kontaktierungselementen (6; 16) auf der gegenüberliegenden Seite des Halbleitersubstrats (1; 11) elektrisch leitend verbunden ist.

10. Feuchtesensor-Anordnung nach Anspruch 2 und 9, wobei über die Durchkontaktierungen (4; 14) im Halbleitersubstrat (1; 11) die Energieversorgung des Signalverarbeitungsbausteins (2; 12) und die serielle Übertragung der Messgröße an die Folgeelektronik erfolgt.

11. Feuchtesensor-Anordnung nach Anspruch 4 und 9, wobei der Signalverarbeitungsbaustein (2; 12) auf seiner dem Feuchtesensor (3; 13) zugewandten Seite eine Isolationsschicht (2.2; 12.2) aufweist, auf der die mindestens eine Grundelektrode (3.1; 13.1a, 13.1b) des Feuchtesensors (3; 13) angeordnet ist, über der die feuchteempfindliche Messschicht (3.3; 13.3) des Feuchtesensors (3; 13) angeordnet ist und über der die Deckelektrode (3.2; 13.2) des Feuchtesensors (3; 13) angeordnet ist.

12. Feuchtesensor-Anordnung nach mindestens einem der Ansprüche 1 - 8, wobei der Feuchtesensor (23; 33) und der Signalverarbeitungsbaustein (22; 32) auf gegenüberliegenden Seiten des Halbleitersubstrats (21; 31) angeordnet und über die Durchkontaktierungen (24; 34) im Halbleltersubstrat (21; 31) elektrisch leitend miteinander verbunden sind.

## Claims

1. Moisture sensor arrangement comprising
- a plate-like semiconductor substrate (1; 11; 21; 31),
- an integrated signal processing module (2; 12; 22; 32) arranged directly adjacent on one side of the semiconductor substrate (1; 11; 21; 31) and configured as a packageless CMOS layer stack,
- a capacitive moisture sensor (3; 13; 23; 33), which is electrically conductively connected to the signal processing module (1; 11; 21; 31) and is arranged either on the same side of the semiconductor substrate (1; 11; 21; 31) as the signal processing module (2; 12; 22; 32) or on the opposite side of said semiconductor substrate to said signal processing module, wherein
- the semiconductor substrate (1; 11; 21; 31) has plated-through holes (4; 14; 24; 34) via which elements on opposite sides of the semiconductor substrate (1; 11; 21; 31) are electrically connectable to one another, and
- at least one temperature sensor (5; 15; 25; 35) integrated in the signal processing module (2; 12; 22; 32).

2. Moisture sensor arrangement according to Claim 1, wherein the signal processing module (2; 12; 22; 32) comprises at least the following further components:
- at least one analogue-to-digital converter unit for reading in and digitizing the analogue measurement signals of the moisture sensor (3; 13; 23; 33) and of the temperature sensor (5; 15; 25; 35),
- an evaluation unit for determining the measurement variable from the measurement signals read in,
- a digital interface unit for serially transmitting the measurement variable determined to subsequent electronics disposed downstream.

3. Moisture sensor arrangement according to Claim 1, wherein the capacitive moisture sensor (3; 13; 23; 33) comprises at least two electrodes (3.1, 3.2; 13.1a, 13.1b, 13.2; 23.1, 23.2; 33.1a, 33.1b, 33.2) and a moisture-sensitive measurement layer (3.3; 13.3; 23.3; 33.3).

4. Moisture sensor arrangement according to Claim 3, wherein the capacitive moisture sensor (3; 13; 23; 33) is configured as a plate capacitor having at least one bottom electrode (3.1; 13.1a, 13.1b, 23.1; 33.1a, 33.1b) and at least one top electrode (3.2; 13.2; 23.2; 33.3), between which the moisture-sensitive measurement layer (3.3; 13.3; 23.3; 33.3) is arranged.

5. Moisture sensor arrangement according to Claim 3, wherein the moisture sensor (3; 23) comprises a single planar bottom electrode (3.1; 23.1) and a single planar top electrode (3.2; 23.2), which are each electrically conductively connected to the signal processing module (2; 22).

6. Moisture sensor arrangement according to Claim 3, wherein the moisture sensor (13; 33) comprises a plurality of planar bottom electrodes (13.1a, 13.1b; 33.1a, 33.1b) and a single planar top electrode (13.2; 33.2) and only the bottom electrodes (13.1a, 13.1b; 33.1a, 33.1b) are electrically conductively connected to the signal processing module (12; 32).

7. Moisture sensor arrangement according to at least one of the preceding claims, wherein spherical contacting elements (6) are arranged on the opposite side of the semiconductor substrate (1; 11; 21; 31) with respect to the moisture sensor (3; 13; 23; 33).

8. Moisture sensor arrangement according to Claim 2, which furthermore comprises a non-volatile memory, in which calibration data regarding the temperature sensor (5; 15; 25; 35) are stored, which are accessed by the evaluation unit for temperature determination.

9. Moisture sensor arrangement according to at least one of Claims 1-8, wherein the moisture sensor (3; 13) is arranged in a vertical direction above the signal processing module (2; 12) and the signal processing module (2; 12) is electrically conductively connected to contacting elements (6; 16) on the opposite side of the semiconductor substrate (1; 11) via the plated-through holes (4; 14) in the semiconductor substrate (1; 11).

10. Moisture sensor arrangement according to Claims 2 and 9, wherein the energy supply of the signal processing module (2; 12) and the serial transmission of the measurement variable to the subsequent electronics are carried out via the plated-through holes (4; 14) in the semiconductor substrate (1; 11).

11. Moisture sensor arrangement according to Claims 4 and 9, wherein the signal processing module (2; 12) has on its side facing the moisture sensor (3; 13) an insulation layer (2.2; 12.2), on which is arranged the at least one bottom electrode (3.1; 13.1a, 13.1b) of the moisture sensor (3; 13), above which is arranged the moisture-sensitive measurement layer (3.3; 13.3) of the moisture sensor (3; 13) and above which is arranged the top electrode (3.2; 13.2) of the moisture sensor (3; 13) .

12. Moisture sensor arrangement according to at least one of Claims 1 - 8 wherein the moisture sensor (23; 33) and the signal processing module (22; 32) are arranged on opposite sides of the semiconductor substrate (21; 31) and are electrically conductively connected to one another via the plated-through holes (24; 34) in the semiconductor substrate (21; 31) .

## Revendications

1. Ensemble de capteur d'humidité présentant
un substrat semi-conducteur (1; 11; 21; 31) en forme de plaque,
un module intégré (2; 12; 22; 32) de traitement de signaux disposé sur un côté du substrat semi-conducteur (1; 11; 21; 31) au voisinage direct de ce dernier et configuré comme empilement sans boîtier de couches (CMOS),
un capteur capacitif d'humidité (3; 13; 23; 33) relié électriquement au substrat semi-conducteur (1; 11; 21; 31) et disposé soit sur le même coté soit sur le côté du substrat semi-conducteur (1; 11; 21; 31) situé face au module intégré (2; 12; 22; 32) de traitement de signaux,
le substrat semi-conducteur (1; 11; 21; 31) présentant des perforations de contact (4; 14; 24; 34) par lesquelles des éléments situés sur des côtés opposés du substrat semi-conducteur (1; 11; 21; 31) peuvent être raccordés électriquement les uns aux autres et
au moins un capteur de température (5; 15; 25; 35) intégré dans le module intégré (2; 12; 22; 32) de traitement de signaux.

2. Ensemble de capteur d'humidité selon la revendication 1, dans lequel le module intégré (2; 12; 22; 32) de traitement de signaux comporte au moins les autres composants suivants :
au moins une unité de conversion analogique-numérique qui lit et numérise les signaux analogiques de mesure du capteur capacitif d'humidité (3; 13; 23; 33) et du capteur de température (5; 15; 25; 35),
une unité d'évaluation qui détermine les grandeurs de mesure à partir des signaux de mesure qui ont été lus et
une unité d'interface numérique pour le transfert série à une électronique de suivi raccordée en aval les grandeurs de mesure qui ont été déterminées.

3. Ensemble de capteur d'humidité selon la revendication 1, dans lequel le capteur capacitif d'humidité (3; 13; 23; 33) comporte au moins deux électrodes (3.1, 3.2; 13.1a, 13.1b, 13.2; 23.1, 23.2; 33.1a, 33.1b, 33.2) et une couche de mesure (3.3; 13.3; 23.3; 33.3) sensible à l'humidité.

4. Ensemble de capteur d'humidité selon la revendication 3, dans lequel le capteur capacitif d'humidité (3; 13; 23; 33) est configuré comme condensateur à plaques présentant au moins une électrode de base (3.1; 13.1a, 13.1b; 23.1; 33.1a, 33.1b) et au moins une électrode de recouvrement (3.2; 13.2; 23.2; 33.3) entre lesquelles est disposée la couche de mesure (3.3; 13.3; 23.3; 33.3) sensible à l'humidité.

5. Ensemble de capteur d'humidité selon la revendication 3, dans lequel le capteur d'humidité (3; 23) comporte une seule électrode de base (3.1; 23.1) plate et une seule électrode de recouvrement (3.2; 23.2) plate reliée de manière électriquement conductrice au module (2; 22) de traitement des signaux.

6. Ensemble de capteur d'humidité selon la revendication 3, dans lequel le capteur d'humidité (13; 33) présente plusieurs électrodes de base plates (13.1a, 13.1b; 33.1a, 33.1b) et une seule électrode de recouvrement plate (13.2; 33.2), seules les électrodes de base électrode de base (13.1a, 13.1b; 33.1a, 33.1b) étant reliées de manière électriquement conductrice au module (12; 32) de traitement des signaux.

7. Ensemble de capteur d'humidité selon au moins l'une des revendications précédentes, dans lequel des éléments de contact (6) de forme sphérique sont disposés sur le côté du substrat semi-conducteur (1; 11; 21; 31) situé face au capteur capacitif d'humidité (3; 13; 23; 33).

8. Ensemble de capteur d'humidité selon la revendication 2, qui comporte en outre une mémoire non volatile dans laquelle des données d'étalonnage du capteur de température (5; 15; 25; 35) sont conservées et à laquelle l'unité d'évaluation a accès pour la détermination de la température.

9. Ensemble de capteur d'humidité selon au moins l'une des revendications 1 à 8, le capteur d'humidité (3; 13) étant disposé dans la direction verticale au-dessus du module (2; 12) de traitement des signaux et le module (2; 12) de traitement des signaux est relié de manière électriquement conductrice par les passages de contact (4; 14) ménagés dans le substrat semi-conducteur (1; 11) avec les éléments de contact (6; 16) disposés sur le côté opposé du substrat semi-conducteur (1; 11).

10. Ensemble de capteur d'humidité selon les revendications 2 et 9, dans lequel l'alimentation en énergie du module (2; 12) de traitement des signaux et le transfert série des grandeurs de mesure à l'électronique de suivi s'effectue par l'intermédiaire des passages de contact (4; 14) ménagés dans le substrat semi-conducteur (1; 11).

11. Ensemble de capteur d'humidité selon les revendications 4 et 9, dans lequel le module (2; 12) de traitement des signaux présente sur son côté tourné vers le capteur d'humidité (3; 13) une couche isolante (2.2; 12.2) sur laquelle sont disposées la ou les électrodes de base (3.1; 13.1a, 13.1b) du capteur d'humidité (3; 13) et par laquelle la couche de mesure (3.3; 13.3) sensible à l'humidité du capteur d'humidité (3; 13) est disposée et au-dessus de laquelle l'électrode de recouvrement (3.2; 13.2) du capteur d'humidité (3; 13) est disposée.

12. Ensemble de capteur d'humidité selon au moins l'une des revendications 1 à 8, dans lequel les capteurs d'humidité (23; 33) et le module (22; 32) de traitement des signaux sont disposés sur des côtés opposés du substrat semi-conducteur (21; 31) et sont reliés mutuellement de manière électriquement conductrice par l'intermédiaire des passages de contact (24; 34) ménagés dans le substrat semi-conducteur (21; 31).
